# EUROPÄISCHE PATENTSCHRIFT

(11) **EP 1 266 231 B1**
(45) Veröffentlichungstag und Bekanntmachung des Hinweises auf die Patenterteilung: **13.10.2004**
(21) Anmeldenummer: 01915365.9
(22) Anmeldetag: 16.03.2001
(51) Int. Cl.: G01R 15/18

(54) **MESSWANDLER**
INSTRUMENT TRANSFORMER
TRANSFORMATEUR DE MESURE

(30) Priorität: 17.03.2000 DE 10013143
(43) Veröffentlichungstag der Anmeldung: 18.12.2002
(73) Patentinhaber: AEG Niederspannungstechnik GmbH & Co. KG, 24534 Neumünster (DE)
(72) Erfinder: GIDAY, Zoltan, 24536 Neumünster (DE); HESS, Burkhard, 24537 Neumünster (DE)
(74) Vertreter: Leson, Thomas Johannes Alois, Dipl.-Ing.
(86) Internationale Anmeldenummer: PCT/EP2001/003041
(87) Internationale Veröffentlichungsnummer: WO 2001/069271

(56) Entgegenhaltungen:
- EP-A- 0 118 269
- EP-A- 0 456 583
- EP-A- 0 650 172

## Beschreibung

Die Erfindung bezieht sich auf einen Messwandler mit einer Primärwicklung, einer Sekundärwicklung und einem Gehäuse zum Aufnehmen der Sekundärwicklung, wobei die Primärwicklung auf die Außenseite des Gehäuses gewickelt ist.

Messwandler sind Transformatoren, an die man Messgeräte anschließt. An Spannungswandler schließt man Spannungsmesser oder Spannungspfade von Messgeräten an, an Stromwandler Strommesser oder Strompfade.

Spannungswandler werden meist in Hochspannungsanlagen verwendet, um die Hochspannung vom Messplatz fernzuhalten. Der Anschluss von Spannungswandlern erfolgt wie der Anschluss eines Transformators.

Stromwandler werden in Niederspannungsanlagen verwendet, um Messinstrumente mit kleinem Messbereich einsetzen zu können. In Hochspannungsanlagen verwendet man Stromwandler auch bei schwachen Strömen, um die Hochspannung vom Messplatz fernzuhalten. Beim Stromwandler ist die Eingangs- oder Primärwicklung in Reihe mit dem Verbraucher geschaltet. Der gesamte Last- oder Netzstrom fließt dann durch die Primärwicklung. Der Netzstrom und der Strom in der durch den Strommesser nahezu kurzgeschlossenen Ausgangs- oder Sekundärwicklung verhalten sich umgekehrt wie die Windungszahlen. Die magnetische Flussdichte im Eisenkern ist dabei sehr gering, weil beide Durchflutungen entgegengesetzte Felder gleicher Stärke hervorrufen.

Stromwandler werden beispielsweise zur Strommessung in elektronischen Auslösevorrichtungen verwendet, mittels denen ein Unterbrecherkontakt beispielsweise einer Schutzschaltung gesteuert wird. In elektronischen Auslöseeinrichtungen für niedrige Strompegel von 25 A oder weniger sind primärseitig mehrere Wicklungen erforderlich, um eine ausreichende Durchflutung sicherzustellen. Im Falle eines Kurzschlusses treten primärseitig hohe Kurzschluss- oder Grenzströme auf, wobei die dann auf die Primärwicklungen einwirkenden magnetischen Kräfte (d. h. Lorenzkräfte) so groß werden, dass sich die Wicklungen gegenseitig verschieben, was zu Beschädigungen führen kann.

Stromwandler oder andere Messwandler mit mehreren Primärwicklungen, die einen maximal auftretenden primärseitigen Durchlassgrenzstrom ohne Beschädigung überstehen können, sind somit wünschenswert.

In der Druckschrift EP-A-0 456 583 ist ein homopolarer Transformator gezeigt, der ein Gehäuse mit auf der Außenseite angeordneten Vertiefungen aufweist, in die Wicklungen der Primärwicklung aufgenommen werden.

Es ist eine Aufgabe der vorliegenden Erfindung, einen Messwandler der eingangs genannten Art mit hoher Stromtragfähigkeit bereitzustellen.

Diese Aufgabe wird gelöst durch einen Messwandler gemäss Patentanspruch 1.

Durch die seitliche Fixierung der Wicklungen der Primärwicklung bzgl. des Gehäuses ist ein gegenseitiges Verschieben der einzelnen Wicklungen aufgrund der durch den hohen Primärstrom hervorgerufenen Ablenkkräfte nicht mehr möglich, so dass eine Beschädigung der Primärwicklungen auch bei hohen Grenzströmen vermieden werden kann.

Vorzugsweise kann die seitliche Fixierung bzgl. des Gehäuses durch Fixiernuten erzielt werden, die an der Außenseite des Gehäuses angeordnet sind, wobei die Wicklungen der Primärwicklung zumindest teilweise in den Fixiernuten geführt sind. Durch die Fixiernuten wird eine seitliche Verschiebung und damit Beschädigung der Wicklungen vermieden. Die Fixiernuten können beispielsweise eine Klemmfunktion zum Einklemmen der Wicklungen aufweisen, so dass eine zusätzliche Fixierung in vertikaler Richtung sichergestellt ist. Dadurch kann beispielsweise die Montage vereinfacht werden.

Es können drei Gruppen von Fixiernuten an unterschiedlichen Stellen auf der Außenseite des Gehäuses angeordnet sein, so dass die in den Fixiernutengruppen geführten Wicklungen verschiedener Gruppen einen vorbestimmten Winkel zueinander aufweisen. Durch diese Beabstandung der Primärwicklungen auf dem Gehäuse kann eine verbesserte Verteilung der auf den Messwandler einwirkenden Kräfte erreicht werden.

Die Primärwicklung kann aus mehreren parallelgeschalteten Wicklungen gebildet sein. Dies führt zu einem geringen Gesamtdurchmesser der Primärwicklung und einer ausreichenden Flexibilität des Primärwicklungsleiters. Ferner wird durch diese Ausgestaltung sichergestellt, dass die Primärwicklungen einen ausreichend geringen Durchmesser aufweisen, um bei einem torusförmigen Gehäuse durch die mittlere Öffnung des Torus geführt werden zu können. Es können beispielsweise drei Wicklungen parallelgeschaltet sein, wobei diese unter verschiedenen Winkeln auf dem Gehäuse geführt sind. Die parallelgeschalteten Wicklungen können an einer Anschlussklemme, die beispielsweise zum Zuführen des Primärstroms verwendet wird, elektrisch verbunden sein. Dabei kann die Anschlussklemme Fixierkerbungen aufweisen, zum Aufnehmen der Enden der Wicklungen. Ferner können Löcher in der Anschlussklemme gebildet sein, durch die die Enden der Wicklungen geführt sind. Die Durchführung der Leitungsenden durch die Löcher und das anschließende Umbiegen der Enden in die Fixierkerbungen ermöglicht ein einfaches Anlöten der Wicklungsenden, wobei die auf die Lötverbindungen wirkenden Spannungen verringert sind.

Das Gehäuse kann beispielsweise durch ein zweitteiliges Kunststoffgehäuse gebildet sein, wobei dessen beiden Hälften steckbar verbunden sind. Auf diese Weise ist ein einfaches Einbringen der Sekundärwicklung möglich. Falls das Gehäuse eine Torusform aufweist, können die Wicklungen der Primärwicklung um den Ringwulst der Torusform geführt und durch axiale Führungsnuten auf dem Außenumfang des Ringwulstes fixiert sein. Die Führungsnuten können gruppenweise auf dem Gehäuse angeordnet sein. So können beispielsweise drei Gruppen der Führungsnuten in einem vorbestimmten Winkelabstand auf dem torusförmigen Gehäuse angeordnet sein. Durch diese beabstandete Anordnung der Führungsnutengruppen können die bei hohen Grenzströmen auftretenden Kräfte ausgeglichen werden, so dass eine Beschädigung der gesamten Messwandleranordnung vermieden wird.

In der mittleren Öffnung des torusfömigen Gehäuses wird erfindungsgemäß ein Führungsstift zum Führen der Wicklungen, der als separates Teil in die Öffnung des Gehäuses einführbar ist, angeordnet. Dieser Führungsstift weist vorzugsweise axiale Führungsnuten zum Aufnehmen einzelner Wicklungen auf. Dadurch wird eine zusätzliche Fixierung der Wicklungen in der mittleren Öffnung des torusförmigen Gehäuses sichergestellt. Des weiteren kann der Führungsstift an zumindest einer Stirnendfläche eine Ausrichtungskontur aufweisen, die in eine an einer Anschlussklemme zum Anschließen des Messwandlers an den zu messenden Schaltkreis eingebrachte Ausrichtungsöffnung eingreift, um die Drehlage des Führungsstifts bezüglich der Anschlussklemme festzulegen. Dadurch kann ein funktionsgerechter Zusammenbau sichergestellt werden. Vorzugsweise werden auch die Wicklungen der Primärwicklung direkt an der Anschlussklemme befestigt (z.B. angelötet).

Die Gehäusehälften des torusförmigen Gehäuses können vorzugsweise so ausgestaltet sein, dass sie ineinander eingreifen, so dass eine Verdrehung der Gehäusehälften verhindert wird. Dies kann dadurch erreicht werden, dass eine Austrittsöffnung zum Hindurchführen der Sekundärwicklungsleiter zweiteilig ausgebildet ist, wobei ein Teil auf einer der Gehäusehälften angeordnet ist und der andere Teil auf der anderen Gehäusehälfte, und wobei die beiden Teile ineinandergreifen, so dass ein Verdrehen der Gehäusehälften verhindert wird. Dadurch kann eine vorbestimmte Lagebeziehung zwischen der Austrittsöffnung der Sekundärwicklungsleiter und den Anschlussklemmen sichergestellt werden.

Weitere vorteilhafte Weiterbildungen der vorgenannten Erfindung sind in den Unteransprüchen angegeben.

Nachfolgend wird die Erfindung anhand von Ausführungsbeispielen unter Bezugnahme auf die Zeichnungen näher erläutert. Es zeigen:
Fig. 1 eine teilweise auseinandergezogene Darstellung eines Stromwandlers gemäß einem ersten bevorzugten Ausführungsbeispiel,
Fig. 2 eine schräge Vorder- und Rückansicht des Stromwandlers gemäß dem ersten bevorzugten Ausführungsbeispiel ohne primärseitige Anschlussklemmen,
Fig. 3 eine Schrägansicht eines in den Stromwandler gemäß dem ersten bevorzugten Ausführungsbeispiel verwendeten Führungsstifts,
Fig. 4 eine teilweise auseinandergezogene Darstellung eines Stromwandlers gemäß einem zweiten bevorzugten Ausführungsbeispiel,
Fig. 5 eine schräge Vorder- und Rückansicht des Stromwandlers gemäß dem zweiten bevorzugten Ausführungsbeispiel ohne primärseitige Anschlussklemmen, und
Fig. 6 eine Zusammenschaltung dreier Stromwandler gemäß dem ersten Ausführungsbeispiel als dreipolige Stromwandleranordnung.

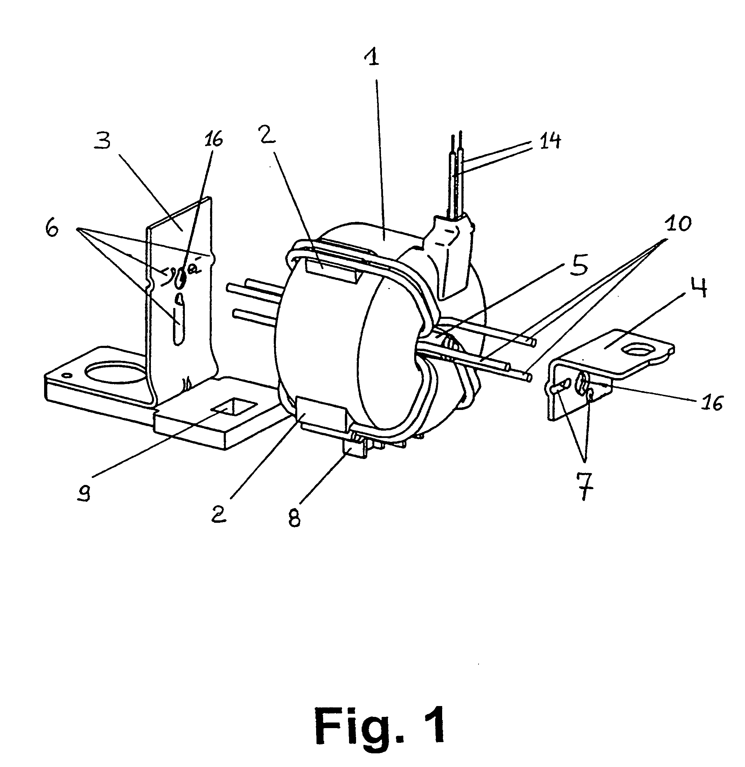

Im Folgenden wird ein erstes bevorzugtes Ausführungsbeispiel eines als Stromwandler eingesetzten Messwandlers unter Bezugnahme auf die Figuren 1 bis 3 erläutert.

Fig. 1 zeigt eine teilweise auseinandergezogene Darstellung des Stromwandlers gemäß dem ersten bevorzugten Ausführungsbeispiel. Ein solcher Stromwandler ist beispielsweise für einen Nennstrom von 25A vorgesehen und umfasst ein schalenförmiges Gehäuse 1, in dem die beispielsweise auf ein ringförmiges Kernmaterial aufgewickelte Sekundärwicklung untergebracht ist. Die Wicklungsleiter 14 der Sekundärwicklung sind durch eine an dem Gehäuse 1 angeordnete Austrittsöffnung nach außen geführt. Für den relativ geringen Nennstrom von 25A sind mehrere Primärwicklungen 10 erforderlich, die gruppenweise unter einem bestimmten Winkelabstand auf das Gehäuse 1 aufgewickelt sind. Die Wicklungen 10 der Primärwicklung sind durch Führungs- oder Fixiernuten 2 in ihrer Lage bezüglich des Gehäuses 1 seitlich fixiert. Die Fixiernuten 2 sind auf der Oberfläche des Gehäuses angeordnet, beispielsweise durch entsprechende Ausgestaltung der Gussform des Kunststoffgehäuses, durch entsprechende Bearbeitung der Gehaüseoberfläche, oder durch Fixieren (beispielsweise Aufkleben) entsprechender Strukturen auf der Gehäuseoberfläche.

Die Primärwicklungen 10 bestehen aus drei einzelnen Wicklungsleitern und weisen somit jeweils drei Enden auf, die an einer jeweiligen Anschlussklemme 3 bzw. 4 zum Anschließen des zu messenden Strompfads befestigt sind. Die Befestigung geschieht dadurch, dass die drei Einzelleiter durch entsprechende Durchgangsöffnungen in den Anschlussklemmen 3 bzw. 4 durchgeführt werden und danach in entsprechende Fixierkerbungen 6 bzw. 7 gebogen werden. Durch diese Maßnahme. ist ein vereinfachtes Anlöten möglich, wobei die Lötstellen geringen Spannungen unterworfen sind. Um die geforderte Stromtragfähigkeit zu erzielen, ist ein bestimmter Querschnitt der Primärwicklungsleitung erforderlich. Ein solcher Querschnitt führt jedoch aufgrund der verringerten Flexibilität des Leiters zu einer schwierigen Handhabung und ein Unterbringen dreier Primärwicklungen in der mittleren Öffnung des in Fig. 1 gezeigten torusförmigen Gehäuses ist nicht möglich. Daher werden die drei Einzelwicklungsleiter mit entsprechend verringertem Querschnitt verwendet und an den Anschlussklemmen 3 und 4 als Parallelschaltung elektrisch verbunden. Dies ermöglicht eine höhere Flexibilität der Wicklungsleiter bei verringertem Platzbedarf in der mittleren Öffnung des torusförmigen Gehäuses.

Zur Verbesserung der Führung der Primärwicklungen ist ein Führungsstift 5 in der mittleren Öffnung des torusförmigen Gehäuses 1 angeordnet, durch den die Wicklungen auch an der den Fixiernuten gegenüberliegenden Seite des Ringwulstes des torusförmigen Gehäuses 1 geführt bzw. fixiert sind. Dies kann beispielsweise durch später erläuterte Führungsnuten des Führungsstifts 5 erzielt werden.

Das Gehäuse 1 weist einen Haltesockel 8 auf, der bei der Montage in eine in einer Haltplatte eingebrachte Halteaussparung 9 eingeführt wird.

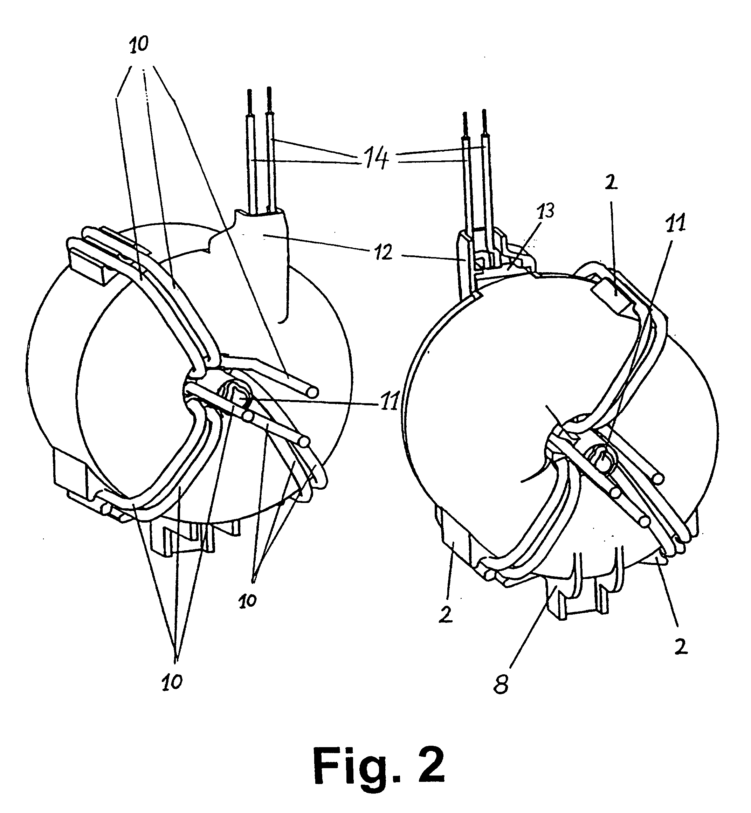

Fig. 2 zeigt eine schräge Vorder- und Rückansicht des Stromwandlers gemäß dem ersten bevorzugten Ausführungsbeispiel ohne die Anschlussklemmen 3 und 4. In dieser Darstellung ist eine an den beiden Stirnendflächen des Führungsstifts 5 angeordnete Ausrichtungskontur 11 erkennbar. Die Ausrichtungskontur kann durch entsprechende Ausgestaltung einer Gussform oder durch Bearbeitung der Oberfläche des Führungsstifts 5 hergestellt werden. Die beiden Ausrichtungskonturen 11 sind passgenau mit den in den Anschlussklemmen 3 und 4 angeordneten Ausrichtungsöffnungen 16 ausgestaltet. Selbstverständlich kann die Ausrichtungskontur 11 auch nur an einer Stirnendfläche vorgesehen sein. Bei der Montage der Anschlussklemmen 3 und 4 kann somit eine vorbestimmte Lage- oder Drehlagebeziehung zwischen dem Führungsstift 5 und den Anschlussklemmen 3 und 4 sichergestellt werden. Diese Lagebeziehung kann beispielsweise so gewählt werden, dass die Austrittsöffnung für die Sekundärleiter 14 senkrecht zur Anschlussfläche der Anschlussklemme 4 angeordnet ist.

Die Austrittsöffnung für die Sekundärleiter 14 ist zweiteilig ausgebildet, wobei ein kanalförmig ausgebildeter Teil 12 an der einen Gehäusehälfte angeordnet ist und ein in den kanalförmigen Teil 12 eingreifender Teil 13 als Kanalverschluss mit zwei Austrittsöffnungen für die beiden Enden der Sekundärleiter 14 ausgebildet ist. Die beiden Gehäusehälften können ineinander geschoben oder gesteckt werden, wobei der schließende Teil 13 der Austrittsöffnung in den kanalförmigen Teil 12 eingreift, so dass ein Verdrehen der beiden ineinandergeschobenen Gehäusehälften verhindert wird. Hierdurch wird gleichzeitig auch eine Zugentlastung erreicht.

Beim Vorliegen des maximalen primärseitigen Grenzstroms (beispielsweise der maximale Auslösestrom einer Schalteinrichtung, für die der Stromwandler vorgesehen ist) führen die hohen auf die primärseitigen Wicklungen wirkenden Kräfte zu einer starken Beanspruchung des Gehäuses 1. Zur Vermeidung einer Beschädigung des Aufbaus des Stromwandlers sind die Fixiernuten 2 in Gruppen angeordnet, die einen vorbestimmten Winkelabstand aufweisen. Die Gruppen können beispielsweise in gleichen Winkelabständen von 120° auf der Oberfläche des torusförmigen Gehäuses 1 angeordnet sein. Im vorliegenden Fall des ersten bevorzugten Ausführungsbeispiels ist eine ungleichmäßige Winkelverteilung vorgesehen. Die optimale Winkelanordnung der Fixiernutengruppen zum bestmöglichen Ausgleich der Verschiebungskräfte kann messtechnisch ermittelt werden.

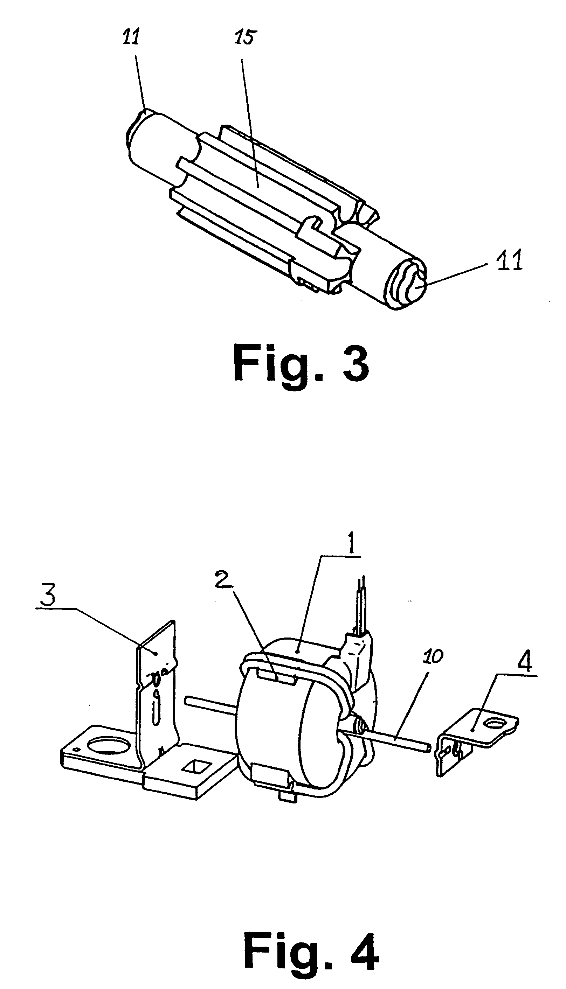

Fig. 3 zeigt eine getrennte Darstellung des Führungsstifts 5, der in der mittleren Öffnung des torusförmigen Gehäuses 1 angeordnet ist. Wie bereits erwähnt, weist der Führungsstift 5 Führungsnuten 15 auf, in denen die primärseitigen Wicklungen geführt werden. Damit können die Wicklungen auch an der Innenseite der Ringwulst des torusförmigen Gehäuses 1 geführt oder fixiert werden. An den beiden Stirnenden des in Fig. 3 gezeigten Führungsstifts 5 sind die Ausrichtungskonturen 11 erkennbar.

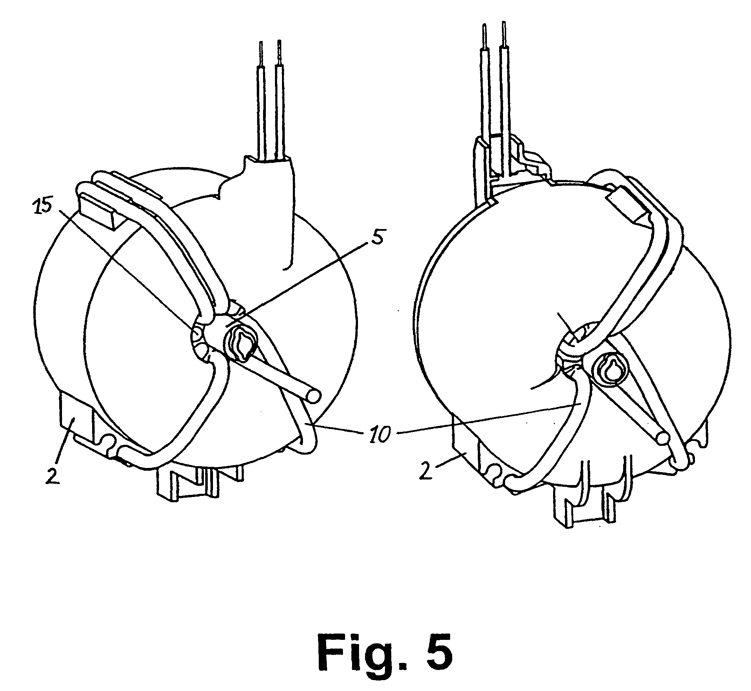

Im folgenden wird ein zweites bevorzugtes Ausführungsbeispiel für einen geringeren primärseitigen Nennstrom von 7A unter Bezugnahme auf die Figuren 4 und 5 beschrieben. Der Stromwandler gemäß dem zweiten bevorzugten Ausführungsbeispiel weist im wesentlichen denselben Aufbau wie der des ersten bevorzugten Ausführungsbeispiels auf. Im Gegensatz zum ersten bevorzugten Ausführungsbeispiel ist jedoch bei dem Stromwandler gemäß dem zweiten bevorzugten Ausführungsbeispiel aufgrund des geringeren Nennstroms nur ein Primärwicklungsleiter erforderlich, wobei aber vier Wicklungen 10 in vorbestimmten Winkelabständen vorgesehen sind. Im vorliegenden Fall sind zwei der Wicklungen 10 zu einer Gruppe zusammengefasst und die anderen beiden in vorbestimmten Winkelabständen zu der Gruppe angeordnet. Der einzelne Primärwicklungsleiter wird durch eine der in den Anschlussklemmen 3 und 4 angeordneten Öffnungen geführt und in eine der Fixierkerbungen 7 eingebogen und angelötet.

Fig. 5 zeigt eine schräge Vorder- und Rückansicht des Stromwandlers gemäß dem zweiten bevorzugten Ausführungsbeispiel, wobei die Fixier- bzw. Führungsnuten 15 des Führungsstifts 5 erkennbar sind. Ferner ist erkennbar, dass in dem zweiten bevorzugten Ausführungsbeispiel nicht alle Führungsnuten 15 des Führungsstifts 5 bzw. Fixiernuten 2 belegt sind. Das Stromwandlergehäuse 1 kann somit in Verbindung mit dem Führungsstift 5 für verschiedene Ausführungsbeispiele eingesetzt werden, wodurch ein flexibler Einsatz bei verringerten Kosten möglich ist.

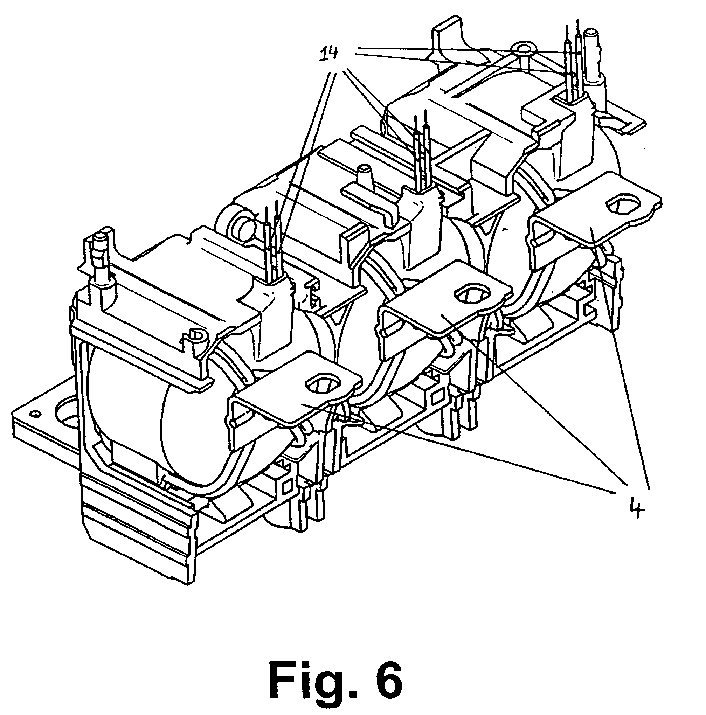

Fig. 6 zeigt eine Anordnung dreier Stromwandler gemäß dem ersten Ausführungsbeispiel als dreipoliger Stromwandler in einer Unterbrechungsschalteinrichtung, die in einem Gussgehäuse untergebracht ist. Das Gussgehäuse weist Öffnungen auf, durch die die sekundärseitigen Austrittsöffnungen mit den Sekundärleitern 14 und die primärseitigen Anschlussklemmen 4 herausgeführt sind. Die anderen primärseitigen Anschlussklemmen 3 der Stromwandler sind elektrisch miteinander verbunden, so dass sich beispielsweise eine Sternkonfiguration für eine Drehstromanwendung ergibt.

Selbstverständlich sind auch vier- oder mehrpolige Unterbrechungsschalteinrichtungen denkbar.

Wie in den Figuren 2 und 5 erkennbar ist, können die Fixiernuten 2 eine Klemmfunktion aufweisen, wobei die Primärwicklungen in die Fixiernuten 2 eingeklemmt werden, so dass eine einfache Montage und zusätzliche Fixierung in radialer Richtung erzielbar ist.

Es ist anzumerken, dass die vorliegende Erfindung nicht auf die konkreten Ausgestaltungen der beiden bevorzugten Ausführungsbeispiele beschränkt ist. Der wesentliche Gedanke der Erfindung liegt in der seitlichen Fixierung der primärseitigen Wicklungen bzgl. der Gehäuseoberfläche. Dies kann auch durch andere geeignete Maßnahmen geschehen, wie beispielsweise Verklebungen, Führungslöcher oder Führungsösen, oder Veränderungen der Gehäuseoberfläche, die zu einer seitlichen Fixierung der primärseitigen Wicklungen in ihrer Lage bezüglich des Gehäuses 1 führen. Auch die Form des Gehäuses 1 ist nicht auf eine Torusform beschränkt, sondern es sind auch andere Gehäuseformen denkbar, in der die Sekundärwicklung untergebracht ist und auf die die Primärwicklung aufgewickelt ist.

## Patentansprüche

1. Messwandler mit einer Primärwicklung, einer Sekundärwicklung und einem Gehäuse (1) zum Aufnehmen der Sekundärwicklung, wobei die Primärwicklung auf die Außenseite des Gehäuses (1) und durch eine Öffnung des Gehäuses (1) gewickelt ist,
wobei der Messwandler eine Fixieranordnung (2, 5) zum seitlichen Fixieren der Lage der Wicklungen (10) der Primärwicklung bzgl. der Außenseite des Gehäuses (1) aufweist, **dadurch gekennzeichnet dass** die Fixieranordnung zusätzlich einen Führungsstift (5) zum Führen der Wicklungen der Primärwicklung umfasst, der als separates Teil in die Öffnung des Gehäuses einführbar ist und die Wicklungen (10) der Primärwicklung in der Öffnung des Gehäuses (1) fixiert.

2. Messwandler nach Anspruch 1, wobei die Fixieranordnung durch Fixiernuten (2) gebildet ist, die an der Außenseite des Gehäuses (1) angeordnet sind, und die Wicklungen (10) der Primärwicklung zumindest teilweise in den Fixiernuten (2) geführt sind.

3. Messwandler nach Anspruch 2, wobei die Fixiernuten (2) eine Klemmfunktion zum Einklemmen der Wicklungen (10) der Primärwicklung aufweisen.

4. Messwandler nach Anspruch 2 oder 3, wobei drei Gruppen von Fixiernuten (2) an unterschiedlichen Stellen auf der Außenseite des Gehäuses (1) angeordnet sind, so dass die in den Fixiernutengruppen geführten Wicklungen (10) verschiedener Gruppen einen vorbestimmten Winkel zueinander aufweisen.

5. Messwandler nach einem der vorgenannten Ansprüche, wobei die Primärwicklung aus mehreren parallelgeschalteten Wicklungen (10) gebildet ist.

6. Messwandler nach Anspruch 5, wobei drei Wicklungen (10) parallelgeschaltet sind und unter verschiedenen Winkeln auf dem Gehäuse (1) geführt sind.

7. Messwandler nach Anspruch 5 oder 6, wobei die parallelgeschalteten Wicklungen (10) an einer Anschlussklemme (3, 4) elektrisch verbunden sind.

8. Messwandler nach Anspruch 7, wobei die Anschlussklemme (3, 4) Fixierkerbungen (6, 7) aufweist zum Aufnehmen der Enden der Wicklungen (10).

9. Messwandler nach Anspruch 8, wobei die Enden der parallelgeschalteten Wicklungen (10) durch in der Anschlussklemme (3, 4) gebildete Löcher geführt sind.

10. Messwandler nach einem der vorgenannten Ansprüche, wobei das Gehäuse (1) ein zweiteiliges Kunststoffgehäuse ist, dessen beide Hälften steckbar verbunden sind.

11. Messwandler nach Anspruch 10, wobei das Gehäuse (1) eine Torusform aufweist und die Wicklungen (10) der Primärwicklung um den Ringwulst der Torusform geführt und durch axiale Führungsnuten (2) auf dem Außenumfang des Ringwulstes in ihrer Lage seitlich fixiert sind.

12. Messwandler nach Anspruch 11, wobei die Führungsnuten (2) gruppenweise auf dem Gehäuse (1) angeordnet sind.

13. Messwandler nach Anspruch 12, wobei drei Gruppen der Führungsnuten (2) um einen vorbestimmten Winkel auf dem torusförmigen Gehäuse (1) voneinander beabstandet angeordnet sind.

14. Messwandler nach Anspruch 1, wobei der Führungsstift (5) axiale Führungsnuten (15) zum Aufnahmen einzelner Wicklungen (10) aufweist.

15. Messwandler nach Anspruch 1 oder 14, wobei der Führungsstift (5) an zumindest einer Stirnendfläche eine Ausrichtungskontur (11) aufweist, die in eine an einer Anschlussklemme (3, 4) eingebrachte Ausrichtungsöffnung (16) eingreift, um die Drehlage des Führungsstifts (5) bzgl. der Anschlussklemme (3, 4) festzulegen.

16. Messwandler nach Anspruch 15, wobei die Wicklungen (10) der Primärwicklung an der Anschlussklemme (3, 4) befestigt sind.

17. Messwandler nach einem der Ansprüche 11 bis 16, wobei die Gehäusehälften des torusförmigen Gehäuses (1) ineinander eingreifen, so dass ein Verdrehen der Gehäusehälften verhindert wird.

18. Messwandler nach Anspruch 17, wobei eine Austrittsöffnung zum Hindurchführen der Sekundärwicklungsleiter (14) zweiteilig ausgebildet ist, wobei ein Teil (12) auf einer der Gehäusehälften angeordnet ist und der andere Teil (13) auf der anderen Gehäusehälfte, und wobei die Teile ineinandergreifen, so dass ein Verdrehen der Gehäusehälften verhindert wird.

19. Verwendung eines Messwandlers nach einem der vorhergehenden Ansprüche als Stromwandler, dem ein Stromsignal zugeführt wird und der das Stromsignal umwandelt.

20. Verwendung nach Anspruch 19, wobei drei Messwandler zu einem dreipoligen Stromwandler verschaltet sind.

21. Verwendung eines Stromwandlers nach einem der Ansprüche 19 oder 20 in einer elektronischen Auslösevorrichtung.

## Claims

1. Measuring transformer with a primary winding, a secondary winding and a housing (1) receiving the secondary winding, whereby the primary winding is wound on the outside of the housing (1) and through an opening in the housing (1),
whereby the measuring transformer possesses a fixing arrangement (2, 5) for lateral fixing of the position of the windings (10) of the primary winding in relation to the outside of the housing (1), **characterised in that** the fixing arrangement additionally comprises a guide pin (5) for guiding the windings of the primary winding which can be introduced into the opening of the housing as a separate part and which fixes the windings (10) of the primary winding in the opening of the housing (1).

2. Measuring transformer in accordance with claim 1, whereby the fixing arrangement is formed by fixing grooves (2) which are arranged on the outside of the housing (1), and the windings (10) of the primary winding are, at least partially, guided in the fixing grooves (2).

3. Measuring transformer in accordance with claim 2, whereby the fixing grooves (2) have a clamping function for clamping in place the windings (10) of the primary winding.

4. Measuring transformer in accordance with claim 2 or 3, whereby three groups of fixing grooves (2) are arranged at different positions on the outside of the housing (1), so that the windings (10) of different groups guided in the groups of fixing grooves are arranged at a predetermined angle in relation to one another.

5. Measuring transformer in accordance with one of the aforementioned claims, whereby the primary winding is formed of several windings (10) connected in parallel.

6. Measuring transformer in accordance with claim 5, whereby three windings (10) are connected in parallel and are guided on the housing (1) at different angles.

7. Measuring transformer in accordance with claim 5 or 6, whereby the parallel-connected windings (10) are connected electrically at a connection terminal (3,4).

8. Measuring transformer in accordance with claim 7, whereby the connection terminal (3, 4) possesses fixing notches (6, 7) to receive the ends of the windings (10).

9. Measuring transformer in accordance with claim 8, whereby the ends of the parallel-connected windings (10) are passed through holes formed in the connection terminal (3, 4).

10. Measuring transformer in accordance with one of the aforementioned claims, whereby the housing (1) is a two-part plastic housing, the two halves of which can be connected by plugging them together.

11. Measuring transformer in accordance with claim 10, whereby the housing (1) is toroidal in form and the windings (10) of the primary winding are passed around the torus and are fixed laterally in position by means of axial guide grooves (2) on the external circumference of the torus.

12. Measuring transformer in accordance with claim 11, whereby the guide grooves (2) are arranged in groups on the housing (1).

13. Measuring transformer in accordance with claim 12, whereby three groups of guide grooves (2) are arranged on the toroidal housing (1) at predetermined angles in relation to one another.

14. Measuring transformer in accordance with claim 1, whereby the guide pin (5) possesses axial guide grooves (15) for receiving individual windings (10).

15. Measuring transformer in accordance with claim 1 or 14, whereby the guide pin (5) possesses an alignment contour (11) on at least one end surface which engages with an alignment opening (16) provided in a connection terminal (3, 4) in order to fix the rotational position of the guide pin (5) in relation to the connection terminal (3, 4).

16. Measuring transformer in accordance with claim 15, whereby the windings (10) of the primary winding are fixed to the connection terminal (3, 4).

17. Measuring transformer in accordance with one of claims 11 to 16, whereby the housing halves of the toroidal housing (1) interlock with one another, so that a rotation of the housing halves is prevented.

18. Measuring transformer in accordance with claim 17, whereby the outlet opening for passing the secondary winding conductor (14) through is formed in two parts, whereby one part (12) is arranged on one of the housing halves and the other part (13) is arranged on the other housing half, and whereby the parts interlock with one another, so that a rotation of the housing halves is prevented.

19. Use of a measuring transformer in accordance with one of the preceding claims as a current transformer to which a current signal is passed and which converts the current signal.

20. Use in accordance with claim 20, whereby three measuring transformers are connected to form a three-pole current transformer.

21. Use of a measuring transformer in accordance with one of claims 19 or 20 in an electronic tripping device.

## Revendications

1. Transformateur de mesure comportant un enroulement primaire, un enroulement secondaire et un boîtier (1) destiné à recevoir l'enroulement secondaire, l'enroulement primaire étant bobiné sur la face extérieure du boîtier (1) et au travers d'une ouverture du boîtier (1), le transformateur de mesure présentant un dispositif de fixation (2, 5) pour fixer latéralement la position des bobinages (10) de l'enroulement primaire par rapport à la face extérieure du boîtier (1), **caractérisé par le fait que** le dispositif de fixation comprend en plus une broche de guidage pour le guidage des bobinages de l'enroulement primaire, qui en tant qu'élément séparé, peut être insérée dans l'ouverture du boîtier et fixe les bobinages (10) de l'enroulement primaire dans l'ouverture du boîtier (1).

2. Transformateur de mesure selon la revendication 1, dans lequel le dispositif de fixation est formé de rainures de fixation (2) qui sont disposées sur la face extérieure du boîtier (1) et les bobinages (10) de l'enroulement primaire sont guidés au moins partiellement dans les rainures de fixation (2).

3. Transformateur de mesure selon la revendication 2, dans lequel les rainures de fixation (2) présentent une fonction de serrage pour bloquer les bobinages (10) de l'enroulement primaire.

4. Transformateur de mesure selon la revendication 2 ou 3, dans lequel trois groupes de rainures de fixation (2) sont disposés en des emplacements différents sur la face extérieure du boîtier (1), de manière telle que les bobinages (10) de groupes différents guidés dans les groupes de rainures de fixation (2) présentent un angle prédéterminé les uns vis-à-vis des autres.

5. Transformateur de mesure selon une des revendications précédentes, dans lequel l'enroulement primaire est formé de plusieurs bobinages (10) connectés en parallèle.

6. Transformateur de mesure selon la revendication 5, dans lequel les trois bobinages (10) sont connectées en parallèle et sont guidés sous des angles différents sur le boîtier (1).

7. Transformateur de mesure selon la revendication 5 ou 6, dans lequel les trois bobinages (10) connectés en parallèle sont reliés électriquement à une borne de connexion (3, 4).

8. Transformateur de mesure selon la revendication 7, dans lequel la borne de connexion (3, 4) présente des gorges de fixation (6, 7) destinées à recevoir les extrémités des bobinages (10).

9. Transformateur de mesure selon la revendication 8, dans lequel les extrémités des bobinages (10) connectés en parallèle pénètrent dans des trous aménagés dans la borne de connexion (3, 4).

10. Transformateur de mesure selon une des revendications précédentes, dans lequel le boîtier (1) est un boîtier en matière plastique en deux parties, dont les deux moitiés sont liées par enfichage.

11. Transformateur de mesure selon la revendication 10, dans lequel le boîtier (1) présente une forme de tore et les bobinages (10) de l'enroulement primaire passent autour du boudin annulaire de la forme de tore et sont fixés dans leur position par des rainures de guidage (2) axiales sur la surface périphérique extérieure du boudin annulaire.

12. Transformateur de mesure selon la revendication 11, dans lequel les rainures de guidage (2) sont disposées par groupes sur le boîtier (1).

13. Transformateur de mesure selon la revendication 12, dans lequel trois groupes de rainures de guidage (2) sont disposés sur le boîtier (1) en forme de tore en étant espacés les uns des autres d'un angle prédéterminé.

14. Transformateur de mesure selon la revendication 1, dans lequel la broche de guidage (5) présente des rainures de guidage (15) axiales pour recevoir des bobinages.

15. Transformateur de mesure selon la revendication 1 ou 14, dans lequel la broche de guidage (5), au moins au niveau d'une face frontale, présente un profil de positionnement (11) qui s'engage dans une ouverture de positionnement (16) aménagée dans une borne de connexion (3, 4) aux fins de fixer la position angulaire de la broche de guidage (5) par rapport à la borne de connexion (3, 4).

16. Transformateur de mesure selon la revendication 15, dans lequel les bobinages (10) sont fixés à la borne de connexion (3, 4).

17. Transformateur de mesure selon une des revendications 11 à 16, dans lequel les moitiés de boîtier du boîtier (1) en forme de tore s'engagent l'une dans l'autre empêchant ainsi une rotation des moitiés de boîtier.

18. Transformateur de mesure selon la revendication 17, dans lequel une ouverture de sortie pour le passage des conducteurs d'enroulement secondaire (14) est réalisée en deux parties, une partie (12) étant disposée dans l'une des moitiés de boîtier et l'autre partie (13) étant disposée dans l'autre moitié de boîtier et les parties s'engageant l'une dans l'autre empêchant ainsi une rotation des moitiés de boîtier est empêchée.

19. Utilisation d'un transformateur de mesure selon une des revendications précédentes en tant que transformateur de courant auquel un signal de courant est appliqué et qui transforme ledit signal de courant.

20. Utilisation d'un transformateur de mesure selon la revendication 19, trois transformateurs de mesure étant connectés pour former un transformateur de courant tripolaire.

21. Utilisation d'un transformateur de mesure selon une des revendications 19 ou 20 dans un dispositif de déclenchement électronique.
